Europäisches Patentamt

European Patent Office

Office européen des brevets

(19)

(11) Publication number : **0 453 279 B1**

(12) **EUROPEAN PATENT SPECIFICATION**

(45) Date of publication of patent specification :
30.08.95 Bulletin 95/35

(51) Int. Cl.⁶ : **H01L 27/118**

(21) Application number : **91303458.3**

(22) Date of filing : **18.04.91**

(54) **Semi-conductor integrated circuit.**

(30) Priority : **20.04.90 JP 104794/90**
 **11.03.91 JP 44840/91**

(43) Date of publication of application :
**23.10.91 Bulletin 91/43**

(45) Publication of the grant of the patent :
**30.08.95 Bulletin 95/35**

(84) Designated Contracting States :
**DE FR GB NL**

(56) References cited :
**EP-A- 0 344 055**
**EP-A- 0 349 294**
**DE-A- 3 715 116**
**PATENT ABSTRACTS OF JAPAN vol. 7, no.
233 (E-204)(1378), 15 October 1983; & JP - A -
58122771 (NIPPON DENKI) 21.07.1983**

(73) Proprietor : **SEIKO EPSON CORPORATION**
**4-1, Nishishinjuku 2-chome**
**Shinjuku-ku Tokyo (JP)**

(72) Inventor : **Tamura, Tsuyoshi, c/o SEIKO
EPSON CORPORATION**
**3-5 Owa 3-chome**
**Suwa-shi, Nagano-ken (JP)**

(74) Representative : **Sturt, Clifford Mark et al**
**J. MILLER & CO.**
**34 Bedford Row**
**Holborn**
**London WC1R 4JH (GB)**

EP 0 453 279 B1

## Description

This invention relates to a semi-conductor integrated circuit having a logical cell composed of insulated gate transistors.

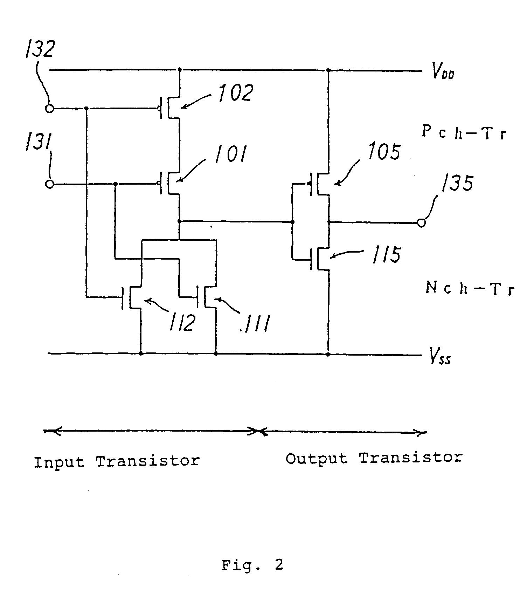

Conventionally, a semi-conductor integrated circuit having a logical cell composed of insulated gate transistors, for example as shown in Figure 2, has a standard cell structure designed manually for each logical cell. In the logical cell shown in Figure 2, transistors 101, 102, 111 and 112 are input transistors while transistors 105 and 115 are output transistors. The transistors 101, 102 and 105 are P-channel insulated gate transistors while the transistors 111, 112 and 115 are N-channel insulated gate transistors. This logical cell has two inputs provided by input terminals 131 and 132, and constitutes and OR circuit wherein the P-channel input transistors 101 and 102 are connected in series. An output terminal 135 of this cell is connected to other cells in the integrated circuit by aluminium wiring.

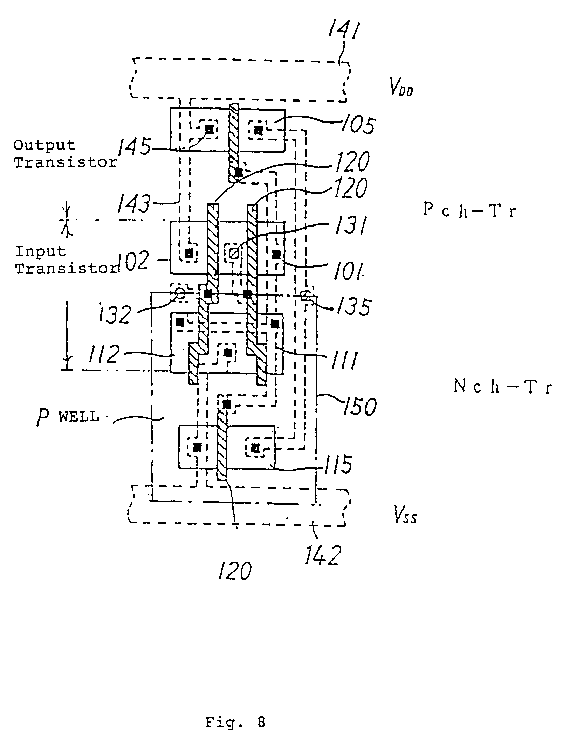

When such a logical cell, in which some of the input transistors are connected in series, is designed manually, the transistors tend to be aligned up and down and right and left, with the wiring inter-mingled, as shown in Figure 8, not only in the case of the OR circuit of Figure 2 but also generally. Figure 8 shows a layout for the OR circuit of Figure 2 wherein the input and output transistors are arranged between power source wirings for supplying a source potential $V_{DD}$ and a ground potential $V_{SS}$, with the input transistors 101, 102, 111 and 112 on the inside, and the output transistors 105 and 115 on the outside. The N-channel transistors 111, 112 and 115 are formed in the domain of a P-type well. The two input terminals 131 and 132 of the cell are connected to respective polysilicon gate electrodes 120 of the transistors 101, 102, 111 and 112. The transistors 101 to 115, the polysilicon gate electrodes 120, aluminium wiring 143 and contacts 145 constitute the OR circuit, and the drains of the output transistors 105 and 115 are connected to the output terminal 135.

In order to accelerate the operation speed of the logical circuit shown in Figure 2, it is necessary to widen the channel width W of the insulated gate transistors. For example, the transition period $t_p$ in the signal rise of the P-channel transistors can be approximated by the following expression:

$$t_p = 4 \times C / (\beta_{po} \times W / n \times V_{DD}) \quad (1)$$

where C is the load capacitance, $\beta_{po}$ is the amplification factor for electric current per unit length of the P-channel transistor, W is the channel width, $n$ is the number of input transistors connected in series, and $V_{DD}$ is the source potential. Since the transition period $t_p$ is inversely proportional to the channel width W, the transition period $t_p$ can be shortened by increasing the channel width W.

In the conventional manually designed structure shown in Figure 8, however, it is necessary to move the transistors 105 and 115 up and down in order to widen the channel width W of the transistors 101, 102, 105, 111, 112 and 115. At the same time, it is also necessary to modify the arrangement of the aluminium wiring 143 and the polysilicon gate electrodes 120, and furthermore to move and correct the contacts 145 for the aluminium wiring 143 and the polysilicon gate electrodes 120 and so on, and through holes in first and second aluminium layers etc. As a result, much time and energy is also required to check the modification.

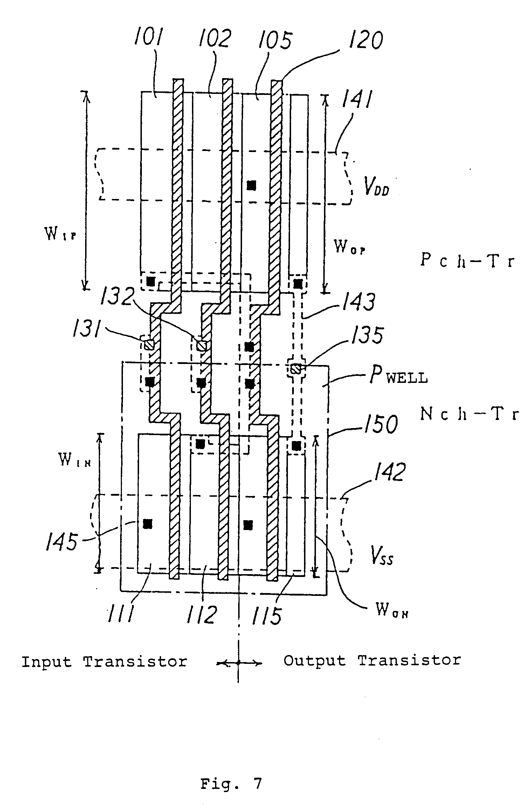

In recent years, a gate array arrangement as shown in Figure 7 has been adopted for providing a standard cell structure to enable cell modification to be carried out easily in a short time. In the gate array arrangement, transistors of the same size are aligned horizontally to constitute a cell, and so the correction mentioned above can be carried out simply by widening the channel width of the transistors. Figure 7 shows an alternative layout for the transistors of the OR circuit of Figure 2. All the P-channel transistors 101, 102 and 105 are of the same size and are formed along the power source wiring 141, and all the N-channel transistors 111, 112 and 115 are of the same size and are formed along the power source wiring 142. Thus, the device as a whole looks like an array. Accordingly, a correction, such as the widening of the channel width, can be carried out flexibly without much need for altering the arrangement of the gate electrodes and the aluminium wiring.

However, such correction results in an increase in electric power consumption because all the transistors in each line are of the same size and so an increase in the channel width of the output transistors 105 and 115 results in an increase in the channel width of the input transistors 101, 102, 111 and 112 also. As a result, the penetrating current $I_S$, which charges and discharges the transistors in operation, increases. For example, the penetrating current $I_S$ of a P-channel transistor can be approximated by the following expression:

$$I_S = 1 / 8 \times \beta_{po} \times W / n \times (V_{DD} - 2 \times Vth)^2 \quad (2)$$

where Vth is the threshold voltage of the transistor and the other symbols are the same as in Equation (1) above. As can be seen, since the penetrating current $I_S$ is proportional to the channel width W, the penetrating current $I_S$ increases as the channel width W increases.

Now, the increase in the speed of operation of an integrated circuit depends on how much the time $T_{trans}$, necessary for a signal from an output of one cell to reach the next cell to which the output is connected, can be shortened. This time $T_{trans}$ can be calculated on the basis of the relation between the total sum of the parasitic capacitance $C_L$ on the output of the cell, as determined by the capacitance of the aluminium wiring connecting the cell and the next cell and by the number of other cells connected to the cell, i.e. the number of fine outs (FO number), and Equation (1). The capacitance of the aluminium wiring is correlated to the chip size of an integrated circuit: the bigger the chip size the bigger the capacitance. And the FO number can also be estimated on the basis of chip size.

The channel width $W_o$ of the output transistor of the cell is determined by $T_{trans}$, calculated as mentioned above, and the frequency band limits in which the chip is used. In the conventional gate array arrangement, the penetrating current of the cell increases substantially with an increase in the channel width of the output transistor because the input transistors have the same channel width as the output transistors proportional to the sum total of the parasitic capacitance $C_L$ on the cell determined as mentioned above. Hence, a significant increase in electric power consumption is required to shorten the operation time in an integrated circuit having a logical cell constructed according to the conventional gate array arrangement.

At present, lap top computers and such like, which are in increasing demand, require an integrated circuit which operates quickly and consumes little electric power because they use a power source, such as a battery, having a limited capacity. Nevertheless, as mentioned above, it is difficult to realise such an integrated circuit using a cell structure obtained by the conventional gate array arrangement, and it is unrealistic to produce such an integrated circuit using the manual design because much time is wasted in modification of the cell structure.

EP-A-0349294 discloses an integrated circuit having I/O cells wherein the output transistors have channel widths greater than those of the input transistors and JP-A-58-122771 discloses an input circuit in which the logic level of the circuit may be readily changed. Neither of these documents is however concerned with internal logic circuits.

The present invention seeks to solve these problems, and an object of the invention is to provide a semi-conductor integrated circuit having a logical cell in which correction can be easily effected and in which increase in electric power consumption can be controlled.

According to a first aspect of the present invention, there is provided a semiconductor integrated circuit having a logical cell comprising insulated gate transistors of a first electric-conductivity type providing input and output transistors, and insulated gate transistors of a second electric-conductivity type providing further input and output transistors, the transistors being formed at regular intervals along respective power source wirings with the channel width of each transistor extending perpendicular to the power source wiring characterised in that the channel width of the or each input transistor of at least one of the first and second electric-conductivity types is less than the channel width of the or each output transistor of said at least one electric-conductivity type, and the gate electrodes of the or each input transistor is parallel to that of the or each output transistor.

By forming the transistors at regular intervals along the associated power source wiring, adjustment can be effected easily. Since the channel width of the transistors are arranged to extend perpendicular to the power source wiring, the channel widths can be changed without modifying the interval at which the transistors are arranged. And by allowing for the channel width of the input transistors to be less than the channel width of the output transistors, it is possible to reduce the penetrating current and hence to decrease the electric power consumption.

Further, the parasitic capacitance on each input transistor of the cell, which is determined simply by the capacitance of the wiring within the cell and the capacitance of the next transistor, is much smaller than the total sum of the parasitic capacitance on the output transistors. The operation time of the cell is thus regulated by the operation time of the output transistors with little contribution from the operation time of the input transistors. Accordingly, although the operation time of the input transistors increases as the channel width of the input transistors decreases, the resulting delay in the operation time of the cell is small since the parasitic capacitance on the input transistors is relatively small. Thus, a semi-conductor integrated circuit in which the channel width of the input transistors is reduced relative to that of the output transistors in order to control increase in electric power consumption can still have a relatively short operation time.

In a preferred form of the invention, a plurality of the input transistors are connected in series and, in this case, it is desirable to increase the channel width of the input transistors as the number in the series increases. This is because the operation time of the input transistors increases as the number $n$ in the series increases, as shown by Equation (1) above, and so it is desirable to lengthen the channel width to compensate for the delay in the operation time.

For example, the channel width $W_I$ of the input transistors may be determined by normalising $W_I$ according to a correlation function $W_I = K (W_o, n)$ where $W_o$ is the channel width of the or each output transistor corresponding to the input transistors connected in series. By normalising the channel width $W_I$ in this way, it becomes easy to correct a mask pattern employed in manufacturing the semi-conductor integrated circuit. More especially, it is necessary to correct the mask pattern employed in manufacture if the channel width of a transistor is adjusted. However, by normalising the channel widths, a set of mask patterns may be prepared in advance and correction of the mask pattern can be effected simply by replacing one mask pattern with another which has already been prepared. The time needed for such correction can thus be much reduced.

The present invention will be described further, by way of example, with reference to the accompanying drawings, in which:-

Figure 1 is a diagram showing the structure of a logical cell of a semi-conductor integrated circuit according to the present invention;

Figure 2 is a circuit diagram of the logical cell shown in Figure 1;

Figure 3 is a diagram showing the structure of a further embodiment of a logical cell of a semi-conductor integrated circuit according to the present invention;

Figure 4 is a circuit diagram of the logical cell shown in Figure 3;

Figure 5 is a plan view showing basic cell components for use in the logical cells of Figures 1 and 3;

Figure 6 is a circuit diagram showing another logical cell containing multi-stage input and intermediate transistors;

Figure 7 is a diagram showing the structure of a logical cell of a conventional semi-conductor integrated circuit having a conventional gate array arrangement; and

Figure 8 is a diagram showing the structure of the same logical cell having a manually designed arrangement.

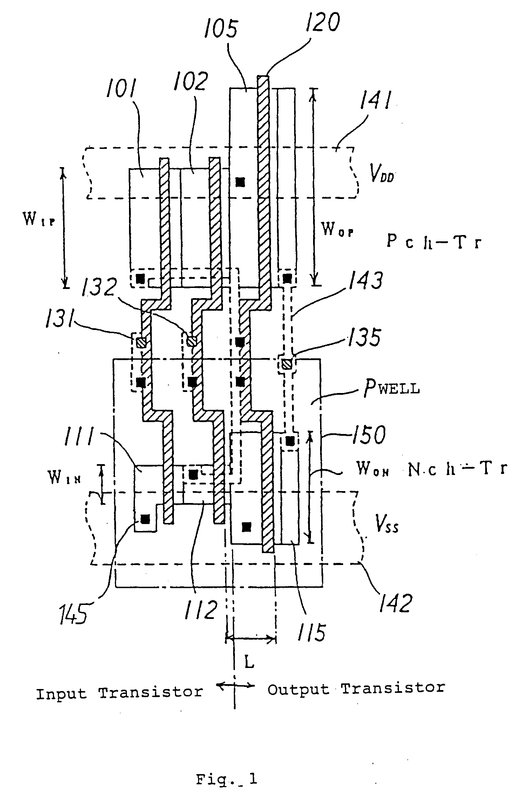

Figure 1 shows the structure of a logical cell of a semi-conductor integrated circuit according to the present invention, having insulated gate transistors. As shown here, P-channel input transistors 101, 102, and a P-channel output transistor 105, N-channel input transistors 111, 112 and an N-channel output transistor 115 are arranged at regular intervals L along power source wirings 141 and 142, which supply a source potential $V_{DD}$ and a ground potential $V_{SS}$, respectively. The N-channel transistors 111, 112 and 115 are formed in a P-type well. The transistors 101 to 115 are arranged with their channel widths $W_{IP}$, $W_{op}$, $W_{IN}$ and $W_{ON}$ extending in a direction at right angles to the power source wirings 141 and 142.

The logical circuit shown in Figure 1 constitutes an OR circuit illustrated in Figure 2. Two input signals are impressed on the P-channel input transistors 101 and 102, which are connected in series, and also on the N-channel input transistors 111 and 112, which are connected in parallel, through input terminals 131 and 132 by way of polysilicon gate electrodes 120. The outputs of the input transistors are applied to the P-channel output transistor 105 and the N-channel output transistor 115, the drains of these transistors being connected to an output terminal 135 via aluminium wiring 143. In this way, the transistors together with the polysilicon gate electrodes 120, the aluminium wiring 143, the input terminals 131 and 132, the output terminal 135 and contacts 145 provide the OR circuit of Figure 2.

The interval L is determined by a design peculiar to the the process and, in this embodiment, is 5 μm. The channel width $W_{OP}$ of the P-channel output transistor and the channel width $W_{ON}$ of the N-channel output transistor are determined by estimating the parasitic capacitance of aluminium wiring driven by the output of the logical cell, and FO number. In this instance, $W_{OP}$ is 20 μm, and $W_{ON}$ is 12 μm. The channel width $W_{IP}$ of the P-channel input transistors is 12 μm while the channel width $W_{IN}$ of the N-channel input transistors is 4 μm.

The penetrating current $I_S$ of the P-channel input transistors in this instance as calculated from Equation (2) is as follows:

$$I_S = 1 / 8 \times \beta_{po} \times W_{IP} / n \times (V_{DD} - 2 \times Vth)^2$$
$$= 1 / 8 \times 15 \times 12 / 2 \times (5 - 2 \times 0.5)^2$$
$$= 180 \ \mu A \quad (3)$$

where the amplification factor of the electric current $\beta_{PO}$ of the P-channel input transistors per unit length is 15 μA/V²/μm, the source potential $V_{DD}$ is 5 V and the threshold voltage Vth is 0.1 x $V_{DD}$.

By contrast, in the prior art as shown in Figure 7, the penetrating current $I_S$ of the P-channel input transistors, whose channel width $W_{IP}$ is the same as the channel width $W_{op}$ of the output transistors and is hence 20 μm, is as follows:

$$I_S = 1 / 8 \times 15 \times 20 / 2 \times (5 - 2 \times 0.5)^2$$
$$= 300 \ \mu A \quad (4)$$

Accordingly, in the present embodiment, the penetrating current $I_S$ can be reduced by about 40% as compared with the corresponding conventional arrangement.

The delay time of the logical cell between the supply of an input and the generation of an output is expressed as follows:

$$Tdr = Tif + Tor$$
$$Tdf = Tir + Tof \quad (5)$$

where Tdr and Tdf are, respectively, the delay time of the rise and the delay time of the fall in the signal between the input and the output; Tif and Tir are the delay time of the fall in the signal and the rise in the signal across the input transistors, respectively; and Tor and Tof are the delay time of the rise in the signal and the fall in the signal across the output transistors, respectively.

The delay time of each transistor is expressed by the transition period $t$ and the delay $T_o$ of a transistor. Assuming that the lag times of each transistor are the same, the delay time Tdf is as follows:

$$Tdf = t_p + t_n + 3 \times T_o \quad (6)$$

Introducing the approximation for the transition period given in Equation (1) above, the delay time Tdf may be expressed as follows:

$$Tdf = 4 \times C_I / (\beta_{po} \times W_{IP} / n \times V_{DD})$$
$$+ 4 \times C_L / (\beta_{NO} \times W_{ON} / n \times V_{DD})$$
$$+ 3 \times T_o \quad (7)$$

where $C_I$ is the parasitic capacitance on an input transistor and is the sum of the wiring capacitance within the cell and the capacitance of the next transistor; $C_L$ is the sum total of the parasitic capacitance on the output transistors, namely the sum total of the capacitance of the aluminium wiring connecting the cell and the next cell with the parasitic capacitance on the output of this cell, or the capacitance of the aluminium wiring times the number of cells connected to this cell (i.e. the FO number); and $\beta_{NO}$ is the amplification factor for the electric current of the N-channel input transistors per unit length. Assuming here that $\beta_{NO}$ is 30 $\mu A/V^2/\mu m$, $C_I$ is 0.1 pF, $C_L$ is 1 pF, and $T_o$ is 0.3 ns, and using the values given above for $\beta_{PO}$, namely 15 $\mu A/V^2/\mu m$, and for the source potential $V_{DD}$, namely 5 V, Tdf can be calculated from Equation (7) as follows:

$$Tdf = 4 \times 0.1 / (15 \times 12 / 2 \times 5)$$
$$+ 4 \times 1.0 / (30 \times 12 / 1 \times 5)$$
$$+ 3 \times 0.3$$
$$= 4.0 \text{ ns} \quad (8)$$

where the channel width $W_{IP}$ of the P-channel input transistors is 12 $\mu m$ and the channel width $W_{ON}$ is also 12 $\mu m$.

On the other hand, in the prior art as shown in Figure 7, the channel width $W_{IP}$ of the P-channel input transistors is 20 $\mu m$ being the same as the channel width $W_{OP}$ of the P-channel output transistor. Calculated in the same way as mentioned above:

$$Tdf = 4 \times 0.1 / (15 \times 20 / 2 \times 5)$$
$$+ 4 \times 1.0 / (30 \times 12 / 1 \times 5)$$
$$+ 3 \times 0.3$$
$$= 3.6 \text{ ns} \quad (9)$$

This would suggest that the delay time in the prior art is reduced by about 10% as compared with the present embodiment of the invention. Nevertheless, in Equations (8) and (9), the value $C_I / C_L$ is about 0.1. In practice, however, this value is imcomparably smaller in an actual integrated circuit. Accordingly, the disparity in delay time will in practice be less than suggested above. Hence, the logical cell according to the invention can be expected to realise about the same delay time as that of the conventional logical cell, whilst by contrast allowing increases in electric power consumption to be controlled.

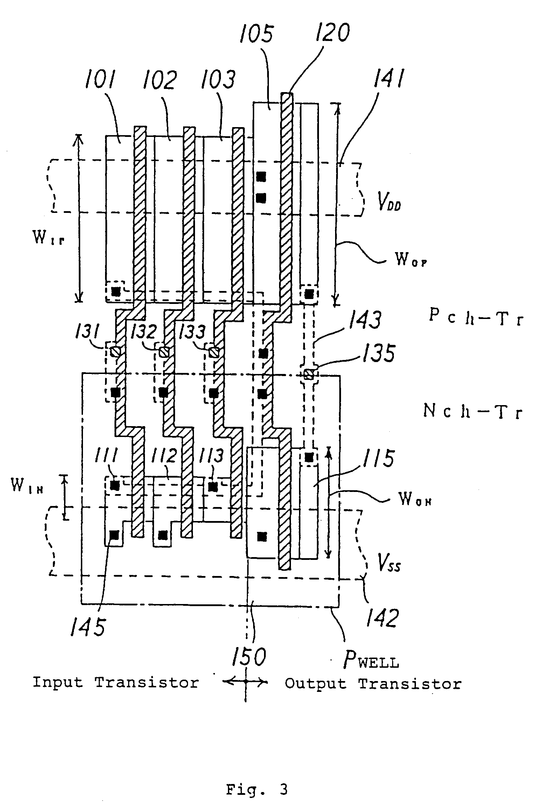

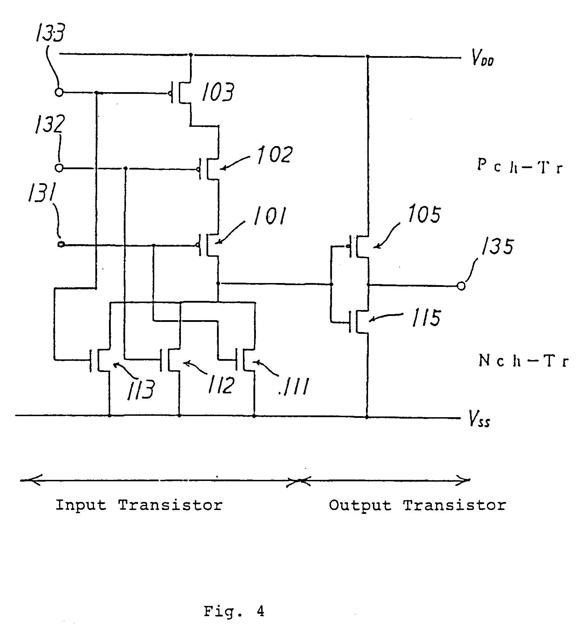

Figure 3 shows the structure of a logical cell, in the form of an OR circuit having three inputs, of another semi-conductor integrated circuit according to this invention. The corresponding OR circuit is shown in Figure 4. In this OR circuit, three P-channel input transistors 101, 102 and 103 are connected in series and three N-channel input transistors 111, 112 and 113 are connected in parallel. Accordingly, as shown in Figure 3, in the structure of the cell, an extra pair of input transistors is added to make two lines of three input transistors. Furthermore, the channel width $W_{IP}$ of the P-channel input transistors is 16 $\mu m$, which is bigger than the channel width $W_{IP}$ of the P-channel input transistors of the logical cell shown in Figure 1.

The other aspects of the structure are the same as in the logical cell shown in Figure 1 and hence will not be described further. The channel width $W_{IP}$ is bigger in this embodiment than in that of Figure 1 in order to compensate for an increase in the transition period $t_p$ : since the transition period $t_p$ is inversely proportional to $\beta_{PO} \times W_{IP} / n$ as shown by Equation (1), it increases as the number n of P-channel transistors in series increases (from two in Figure 1 to three in this embodiment). It is thus desirable to increase the channel width of the P-channel input transistors, within certain limits imposed according to the channel width of the corresponding output transistor, as the number $n$ in the series increases.

Furthermore, in this instance, the P-channel output transistor has a channel width determined by normalising the channel width $W_{IP}$ employing the following correlation function:

$$W_{OP} = k (n) \times W_{IP} \quad (10)$$

where k (n) is a correlation co-efficient, which is 2.5 when n = 1, which is 1.67 when n = 2, which is 1.25 when n = 3, and which is 1.0 when n = 4. Note that, in this instance, the co-efficient is set assuming that the maximum number in the series is four, but the co-efficient can be changed depending on this maximum number in practice and so on.

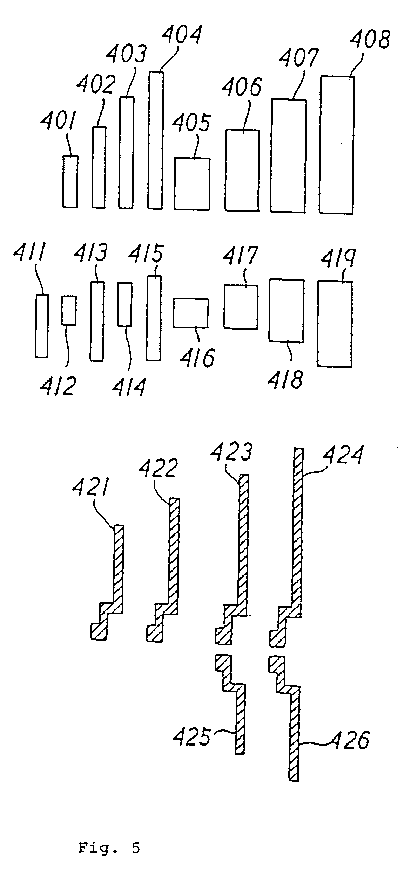

By means of Equation (10), the size of each transistor and the associated parts may be normalised into basic cell components as shown in Figure 5. For example a P-channel input transistor may have a basic cell component 405 with a channel width $W_{IP}$ of 8 $\mu m$ when n = 1; a basic cell component 406 with a channel width $W_{IP}$ of 12 $\mu m$ when n = 2; a basic cell component 407 with a channel width $W_{IP}$ of 16 $\mu m$ when n = 3; and a basic cell component 408 with a channel width $W_{IP}$ of 20 $\mu m$ when n = 4. A similar range of basic cell components serves for the output transistors. In the case of the N-channel transistors, it is possible to prepare in advance a similar range of basic cell components 416 to 149. The cell components 401 to 404 and 411 to 415 provide respectively a source and a drain corresponding to the above basic transistor cell components, and the cell components 421 to 426 provide corresponding polysilicon gate electrodes. By constructing a logical cell using these basic cell components, a change in the structure of the logical cell can be effected simply by selecting amongst cell component designs prepared in advance. In particular, mask patterns corresponding to the above basic cell components can be prepared in advance for use in the manufacture of a semiconductor integrated circuit. Then, when the structure of the logical cell is determined or altered, an appropriate mask pattern can readily be produced in a short time using the mask patterns prepared beforehand. Alterations can, therefore, be flexibly accommodated.

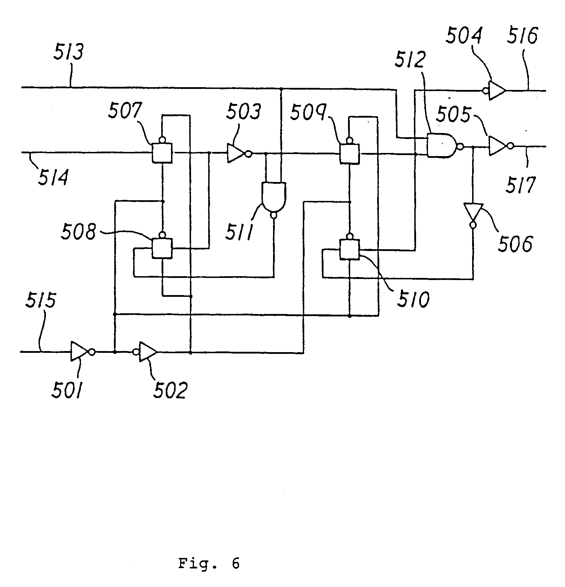

The present invention may also be applied to a logical cell having a complicated structure such as that shown in Figure 6 and containing intermediate transistors providing an intermediate logic for processing input signals in addition to transistors arranged for directly receiving input signals. In this type of cell, the channel width of the intermediate transistors may be narrower, and so the penetrating current of the intermediate transistors will be reduced. Moreover, the parasitic capacitance on the transistors directly receiving the input signals reduces, and so the delay time of these transistors can be shortened to correspond with that in the conventional cell structure. Hence, by applying the invention to a cell realising a complicated logical circuit, it is possible to control even further the increase of the electric power consumption whilst at the same time shortening the delay time. By reducing the channel width of the respective transistors, charging and discharging current and short circuit current within the cell can be expected to be reduced. This, it is anticipated that the electric power consumption in such a semi-conductor chip may be reduced to about half of that in the conventional chip.

Of course, various modifications can be made in the embodiments described above. For example, although the gate electrodes are described as being made from polysilicon, they can be made from various metals. Further, neither the arrangement interval L nor the the channel widths given are to be taken as specified. The correlation function K $(W_On)$ is not fixed either. The P-channel transistors and the N-channel transistors can be reversed, and the well domain can be on the P-channel side instead of the N-channel side as described. Also, the invention can be applied to various logical circuits other than an OR circuit.

By forming the transistors of a logical cell at regular intervals along the associated power source wiring and making the channel width of the input transistors narrower than that of the output transistors, the present invention enables the operation speed of the cell to be increased whilst controlling increases in electric power consumption. The invention may thus provide a semi-conductor integrated circuit which is especially suitable for use in a device, such as a lap top computer, having a limited electric power supply.

Furthermore, by normalising or standardising the channel width of the transistors with a correlation function so as to provide a set of basic cell components, corrections or alterations in the structure of the logical cell can be accommodated easily and quickly.

## Claims

1. A semi-conductor integrated circuit having a logical cell comprising insulated gate transistors of a first electric-conductivity type (101, 102, 105) providing input and output transistors, and insulated gate transistors (111, 112, 115) of a second electric-conductivity type providing further input and output transistors, the transistors being formed at regular intervals along respective power source wirings (141, 142) with the channel width of each transistor extending perpendicular to the power source wiring, the channel width of the or each input transistor of at least one of the first and second electric-conductivity types being less than the channel width of the or each output transistor of said at least one electric-conductivity type, and the gate electrode of the or each input transistor being parallel to that of the or each output transistor.

2. A semi-conductor integrated circuit according to claim 1 characterised in that at least one respective power source wiring has a plurality of input transistors having the same channel width formed there-along.

3. A semi-conductor integrated circuit according to claim 2 characterised in that the channel width of the input transistors formed along at least one respective power source wiring is increased as the number of input transistors is increased.

4. A semi-conductor integrated circuit according to claim 3 characterised in that the channel width of the input transistors formed along at least one respective power source wiring is defined on the basis of a correlation function having as variables the channel width of the or each output transistor formed along the respective power source wiring and a correlation coefficient which is dependent on the number of said serially connected transistors, the correlation coefficient decreasing as the number of transistors increases and wherein the channel width of the or each output transistor is given by the product of the channel width of the respective input transistor and said correlation coefficient.

5. A process for manufacturing a semi-conductor integrated circuit having a logical cell comprising insulated gate transistors (101, 102, 105) of a first electric conductivity type providing input and output transistors, and insulated gate transistors (111, 112, 115) of a second electric conductivity type providing further input and output transistors, which transistors are formed at intervals along respective power source wirings (141, 142), comprising: forming the transistors, such that their channel widths extend perpendicular to the power source wirings and such that the channel width of the or each input transistor of at least one of the first and second electric-conductivity type is less than the channel width of the or each output transistor of said at least one electric-conductivity type, employing a mask pattern having a standardised set of transistor pattern sizes, the gate electrode of the or each input transistor being made parallel to that of each output transistor.

6. A semi-conductor integrated circuit having a logical cell comprising insulated gate type transistors (101, 102, 105) of a first electric conduction type and insulated gate transistors (111, 112, 115) of a second electric conduction type, wherein said transistors are composed of output transistors (105, 115) and input transistors (101, 102, 111, 112) generating signals applied on said output transistors, said transistors being formed at regular intervals along a power source wiring (141, 142) so that the channel widths of said output and input transistors may be at right angles to said power source wiring, the channel width of said input transistors being narrower than that of said output transistors of the same conductivity type.

7. A semi-conductor integrated circuit according to claim 6 characterised in that the input transistors along a respective power source wiring are connected in series, and in that the channel width of said input transistors is defined on the basis of a correlation function having as variables the channel width of the or each output transistor formed along the respective power source wiring and a correlation coefficient which is dependent on the number of said serially connected transistors, the correlation coefficient decreasing as the number of transistors increases and wherein the channel width of the or each output transistor is given by the product of the channel width of the respective input transistor and the correlation coefficient.

8. A manufacturing process of a mask pattern used in producing the semiconductor integrated circuit according to claim 7 characterised in that the pattern normalised with said correlation function is used as said mask pattern of said input and output transistors.

**Patentansprüche**

1. Integrierte Halbleiterschaltung mit einer logischen Zelle, welche als Eingangs- und Ausgangstransistoren vorgesehene Transistoren mit isoliertem Gate eines ersten elektrischen Leitfähigkeitstyps (101, 102, 105) sowie als weitere Eingangs- und Ausgangstransistoren vorgesehene Transistoren mit isoliertem Gate (111, 112, 115) eines zweiten elektrischen Leitfähigkeitstyps umfaßt, wobei die Transistoren in regelmäßigen Intervallen längs jeweiliger Energiequellenverdrahtungen (141, 142) gebildet sind, wobei die Kanalweite jedes Transistors orthogonal zu der Energiequelleverdrahtung verläuft, wobei die Kanalweite des oder jedes Eingangstransistors wenigstens eines der ersten und zweiten elektrischen Leitfähigkeitstypen kleiner als die Kanalweite des oder jedes Ausgangstransistors des wenigstens einen elektrischen Leitfähigkeitstyps ist und wobei die Gate-Elektrode des oder jedes Eingangstransistors parallel zu derjenigen des oder jedes Ausgangstransistors ist.

2. Integrierte Halbleiterschaltung nach Anspruch 1, dadurch gekennzeichnet, daß längs wenigstens einer jeweiligen Energiequellenverdrahtung eine Mehrzahl von Eingangstransistoren gebildet ist, welche die gleiche Kanalweite aufweisen.

3. Integrierte Halbleiterschaltung nach Anspruch 2, dadurch gekennzeichnet, daß die Kanalweite der längs wenigstens einer jeweiligen Energiequellenverdrahtung gebildeten Eingangstransistoren mit zunehmender Zahl der Eingangstransistoren größer wird.

4. Integrierte Halbleiterschaltung nach Anspruch 3, dadurch gekennzeichnet, daß die Kanalweite der längs wenigstens einer jeweiligen Energiequellenverdrahtung gebildeten Eingangstransistoren auf Basis einer Korrelationsfunktion festgelegt ist, welche als Variablen die Kanalweite des oder jedes längs der jeweiligen Energiequellenverdrahtung gebildeten Ausgangstransistors und einen Korrelationskoeffizienten aufweist, der von der Zahl der in Reihe geschalteten Transistoren abhängt, wobei der Korrelationskoeffizient mit zunehmender Zahl der Transistoren abnimmt und wobei die Kanalweite des oder jedes Ausgangstransistors durch das Produkt der Kanalweite des jeweiligen Eingangstransistors und des Korrelationskoeffizienten gegeben ist.

5. Verfahren zum Herstellen einer integrierten Halbleiterschaltung mit einer logischen Zelle, welche als Eingangs- und Ausgangstransistoren vorgesehene Transistoren mit isoliertem Gate (101, 102, 105) eines ersten elektrischen Leitfähigkeitstyps sowie als weitere Eingangsund Ausgangstransistoren vorgesehene Transistoren mit isoliertem Gate (111, 112, 115) eines zweiten elektrischen Leitfähigkeitstyps umfaßt, welche Transistoren in Intervallen längs jeweiliger Energiequellenverdrahtungen (141, 142) gebildet sind, umfassend: Bilden der Transistoren derart, daß ihre Kanalweiten orthogonal zu den Energiequellenverdrahtungen verlaufen und daß die Kanalweite des oder jedes Eingangstransistors wenigstens eines der ersten und zweiten elektrischen Leitfähigkeitstypen kleiner als die Kanalweite des oder jedes Ausgangstransistors des wenigstens einen elektrischen Leitfähigkeitstyps ist, und Verwenden einer Maskenvorlage mit einem standardisierten Satz von Transistorvorlagengrößen, wobei die Gate-Elektrode des oder jedes Eingangstransistors parallel zu derjenigen jedes Ausgangstransistors gemacht wird.

6. Integrierte Halbleiterschaltung mit einer logischen Zelle, welche Transistoren vom Typ mit isoliertem Gate (101, 102, 105) eines ersten elektrischen Leitungstyps sowie Transistoren mit isoliertem Gate (111, 112, 115) eines zweiten elektrischen Leitungstyps umfaßt, wobei die Transistoren aus Ausgangstransistoren (105, 115) und Eingangstransistoren (101, 102, 111, 112), welche Signale erzeugen, die an die Ausgangstransistoren angelegt werden, zusammengesetzt sind, wobei die Transistoren in regelmäßigen Intervallen längs einer Energiequellenverdrahtung (141, 142) gebildet sind, so daß die Kanalweiten der Ausgangs- und Eingangstransistoren rechtwinklig zu der Energiequellenverdrahtung sein können, wobei die Kanalweite der Eingangstransistoren kleiner als diejenige der Ausgangstransistoren des gleichen Leitfähigkeitstyps ist.

7. Integrierte Halbleiterschaltung nach Anspruch 6, dadurch gekennzeichnet, daß die Eingangstransistoren längs einer jeweiligen Energiequellenverdrahtung in Reihe geschaltet sind und daß die Kanalweite der Eingangstransistoren auf Basis einer Korrelationsfunktion festgelegt ist, welche als Variablen die Kanalweite des oder jedes längs der jeweiligen Energiequellenverdrahtung gebildeten Ausgangstransistors und einen Korrelationskoeffizienten aufweist, der von der Zahl der in Reihe geschalteten Transistoren abhängt, wobei der Korrelationskoeffizient mit zunehmender Zahl der Transistoren abnimmt und wobei die Kanalweite des oder jedes Ausgangstransistors durch das Produkt der Kanalweite des jeweiligen Eingangstransistors und des Korrelationskoeffizienten gegeben ist.

8. Herstellungsverfahren für eine bei der Herstellung der integrierten Halbleiterschaltung nach Anspruch 7 verwendete Maskenvorlage, dadurch gekennzeichnet, daß als Maskenvorlage der Eingangs- und Ausgangstransistoren die mit der Korrelationsfunktion normierte Vorlage verwendet wird.

**Revendications**

1. Circuit intégré à semi-conducteur comprenant une cellule logique constituée par des transistors à gâchette isolée (101, 102, 105) d'un premier type de conductivité électrique constituant des condensateurs d'entrée et de sortie, et des transistors à gâchette isolée (111, 112, 115) d'un second type de conductivité électrique constituant d'autres transistors d'entrée et de sortie, les transistors étant formés à intervalles réguliers le long de câblages respectifs (141, 142) de source d'alimentation, la largeur du canal de chaque transistor étant orientée perpendiculairement au câblage de la source d'alimentation, la largeur du canal du ou de chaque transistor d'entrée d'au moins un parmi le premier et le second types de conductivité électrique étant inférieure à la largeur du canal du ou de chaque transistor de sortie du ou d'au moins un premier type de conductivité électrique, et l'électrode de gâchette du ou de chaque transistor d'entrée étant parallèle à celle du ou de chaque transistor de sortie.

2. Circuit intégré à semi-conducteur selon la revendication 1, caractérisé en ce qu'au moins un câblage correspondant de source d'alimentation comprend une pluralité de transistors d'entrée ayant la même largeur de canal, formés sur sa longueur.

3. Circuit intégré à semi-conducteur selon la revendication 2, caractérisé en ce que la largeur du canal des transistors d'entrée formés le long d'au moins un câblage correspondant de source d'alimentation augmente au fur et à mesure que le nombre des transistors d'entrée augmente.

4. Circuit intégré à semi-conducteur selon la revendication 3, caractérisé en ce que la largeur du canal des transistors d'entrée formés le long d'au moins un câblage correspondant de source d'alimentation est définie suivant une fonction de corrélation ayant comme variable la largeur du canal du ou de chaque transistor de sortie formé le long du câblage de source d'alimentation correspondant, et un coefficient de corrélation qui dépend du nombre desdits transistors connectés en série, le coefficient de corrélation diminuant quand le nombre des transistors augmente, et dans lequel la largeur du canal du ou de chaque transistor de sortie est donnée par le produit de la largeur du canal du transistor d'entrée correspondant et dudit coefficient de corrélation.

5. Procédé de fabrication d'un circuit intégré à semi-conducteur comprenant une cellule logique constituée par des transistors à gâchette isolée (101, 102, 105) d'un premier type de conductivité électrique constituant des transistors d'entrée et de sortie, et des transistors à gâchette isolée (111, 112, 115) d'un second type de conductivité électrique constituant d'autres transistors d'entrée et de sortie, lesquels transistors sont formés à intervalles le long de câblages (141, 142) des sources d'alimentation correspondantes, comprenant : la formation des transistors, de manière que les largeurs de leur canal soient perpendiculaires aux câblages des sources d'alimentation, et que la largeur du canal du ou de chaque transistor d'entrée d'au moins un parmi le premier et le second types de conductivité électrique, soit inférieure à la largeur du canal du ou de chaque transistor de sortie dudit premier type de conductivité électrique au moins, en employant une configuration de masque ayant un ensemble normalisé de dimension de configuration de transistor, l'électrode de gâchette du ou de chaque transistor d'entrée étant parallèle à celle de chaque transistor de sortie.

6. Circuit intégré à semi-conducteur comprenant une cellule logique constituée par des transistors (101, 102, 105) du type à gâchette isolée, d'un premier type de conduction électrique et des transistors à gâchette isolée (111, 112, 115) d'un second type de conduction électrique, dans lequel lesdits transistors sont composés de transistors de sortie (105, 115) et de transistors d'entrée (101, 102, 111, 112) générant des signaux appliqués auxdits transistors de sortie, lesdits transistors étant formés à intervalles réguliers le long d'un câblage (141, 142) de source d'alimentation de manière que les largeurs des canaux desdits transistors de sortie et d'entrée puissent être perpendiculaires audit câblage de source d'alimentation, la largeur des canaux desdits transistors d'entrée étant plus étroite que celle desdits transistors de sortie du même type de conductivité.

7. Circuit intégré à semi-conducteur selon la revendication 6, caractérisé en ce les transistors d'entrée placés le long d'un câblage correspondant de source d'alimentation sont connectés en série, et en ce que la largeur des canaux desdits transistors d'entrée est définie suivant une fonction de corrélation ayant comme variable la largeur du canal du ou de chaque transistor de sortie formé le long du câblage de source d'alimentation correspondant, et un coefficient de corrélation qui dépend du nombre desdits transistors connectés en série, le coefficient de corrélation diminuant quand le nombre des transistors augmente, et dans lequel la largeur du canal du ou de chaque transistor de sortie est donnée par le produit de la largeur du canal du transistor d'entrée correspondant et d'un coefficient de corrélation.

8. Procédé de fabrication d'une configuration d'un masque utilisé dans la production du circuit intégré à semiconducteur selon la revendication 7, caractérisé en ce que la configuration normalisée avec ladite fonction de corrélation est utilisée comme dite configuration de masque desdits transistors d'entrée et de sortie.

Fig._1

Fig. 2

Fig. 3

Fig. 4

Fig. 5

Fig. 6

Fig. 7

*141*

$V_{DD}$

*105*

Output
Transistor *145*

*120*

*120*

P c h − T r

*143*

Input
Transistor *102*

*131*

*101*

*132*

*135*

*112*

*111*

N c h − T r

*150*

*P* WELL

*115*

$V_{SS}$

*120*

*142*

Fig. 8